# EUROPEAN PATENT APPLICATION

(11) **EP 3 930 018 A1**
(43) Date of publication of application: **29.12.2021**
(21) Application number: 20759235.3
(22) Date of filing: 19.02.2020
(51) Int. Cl.: H01L 51/40, H01L 51/05, H01L 51/30, H01L 21/336, H01L 29/786

(54) **ORGANIC SEMICONDUCTOR DEVICE, METHOD FOR MANUFACTURING ORGANIC SEMICONDUCTOR SINGLE-CRYSTAL FILM, AND METHOD FOR MANUFACTURING ORGANIC SEMICONDUCTOR DEVICE**

(30) Priority: 22.02.2019 JP 2019030776
(71) Applicant: The University of Tokyo, Bunkyo-ku, Tokyo 113-8654 (JP)
(72) Inventor: TAKEYA, Junichi, Tokyo 113-8654 (JP); WATANABE, Shunichiro, Tokyo 113-8654 (JP); SASAKI, Mari, Tokyo 113-8654 (JP); MAKITA, Tatsuyuki, Tokyo 113-8654 (JP)
(74) Representative: Mewburn Ellis LLP
(86) International application number: PCT/JP2020/006597
(87) International publication number: WO 2020/171131

(57) **Abstract**

The present disclosure provides an organic semiconductor single crystal film that can be disposed on a desired substrate and has a thickness thinner than that of a conventional film. The present disclosure is directed to an organic semiconductor device comprising: a substrate; and an organic semiconductor single crystal film on the substrate, wherein an average film thickness of the organic semiconductor single crystal film is 2 to 100 nm, and at least a portion of a surface of the substrate in contact with the organic semiconductor single crystal film is hydrophobic, solvent soluble, non-heat resistant, or a combination thereof.

## Description

### FIELD

The present disclosure relates to an organic semiconductor device, a method for manufacturing an organic semiconductor single crystal film, and a method for manufacturing an organic semiconductor device.

### BACKGROUND

In recent years, interest in organic semiconductors has been increasing. As features of organic semiconductors, unlike conventional inorganic semiconductors of amorphous silicon and polycrystalline silicon, it mentions that it is excellent in flexibility, that it can be inexpensively enlarged in area by roll to roll processing, etc., and applications of organic semiconductors as post-silicon semiconductors to electronic devices of the next generation type are examined.

In particular, it is known that an organic semiconductor device having excellent characteristics can be manufactured by forming an organic semiconductor single crystal film on a hydrophobic substrate, such as a fluorine-based polymer insulating film.

In addition, as a method for manufacturing an organic semiconductor device, a film forming method such as a coating method or a vapor phase growth method (PVT : Physical Vapor Transport) has been conventionally used (Patent Literature 1 and Non-Patent Literature 1), and in particular, by using a coating method in a film forming method, an improvement in use efficiency of a material and a drastic cost reduction can be expected.

### [CITATION LIST]

### [PATENT LITERATURE]

[PTL 1] Japanese Unexamined Patent Publication No. 2015-185620

### [NON-PATENT LITERATURE]

[NPL 1] Balthasar Blulle, et al., Approaching the trap-free limit in organic single-crystal field-effect transistors, Physical Review Applied 1, 034006 (2014)
[NPL 2] M. Kitamura et al., Work function of gold surfaces modified using substituted benzenethiols: Reaction time dependence and thermal stability, Appl. Phys. Express 7, 035701 (2014)

### SUMMARY

### [TECHNICAL PROBLEM]

However, conventionally, when using the vapor phase growth method, only the organic semiconductor single crystal film having a large thickness of about 2µm could be obtained, and it was difficult to obtain an organic semiconductor single crystal film with a thinner thickness.

In addition, when a coating method is used, an organic semiconductor film could not be formed on a hydrophobic substrate, such as a fluorine-based polymer insulating film.

Further, since an organic solvent is used in the coating method, it has not been possible to apply an organic semiconductor film on a solvent-soluble substrate. Therefore, for example, it has been difficult to form a pn junction structure composed of an organic semiconductor film by a coating method.

Further, when an electrode film, such as Au, is provided on a substrate, a surface of the electrode film is modified with a self-assembled monolayer (SAM : Self-Assembled Monolayer), such as pentafluorobenzenethiol (PFBT) or 4-methylbenzenethiol (MBT), in order to control the work function of the electrode and to improve carrier implantation from the electrode to the organic semiconductor. However, PFBT film and the MBT film have low heat resistance, and the work function control effect is lowered at about 130 to 150 °C for PFBT and about 100 °C for the MBT (Non-Patent Literature 2). Since the coating method is often performed by heating the substrate to about 80 to 150° C, it is sometimes inappropriate to form an organic semiconductor on a substrate having an electrode film of Au or the like by the coating method.

Thus, when using the vapor phase growth method, it has been impossible to obtain an organic semiconductor single crystal film having a thin film thickness, and when using the coating method, there has been a limitation on the substrate.

Therefore, there has been a need for an organic semiconductor single crystal film that can be disposed on a desired substrate and that has a film thickness thinner than the conventional.

### [SOLUTION TO PROBLEM]

(1) An organic semiconductor device comprising: a substrate; and an organic semiconductor single crystal film on the substrate, wherein an average film thickness of the organic semiconductor single crystal film is 2 to 100 nm, and at least a portion of a surface of the substrate in contact with the organic semiconductor single crystal film is hydrophobic, solvent soluble, non-heat resistant, or a combination thereof.
(2) The organic semiconductor device according to (1) above, wherein an area of the organic semiconductor single crystal film is equal to or greater than 2 mm².
(3) A method for manufacturing an organic semiconductor single crystal film, comprising: forming an organic semiconductor single crystal film having an average film thickness of 2 to 100 nm on a hydrophilic and non-water-soluble first substrate using a coating method; and separating the organic semiconductor single crystal film from the first substrate by applying water to an interface between the first substrate and the organic semiconductor single crystal film.
(4) The method for manufacturing an organic semiconductor single crystal film according to (3) above, wherein an area of the organic semiconductor single crystal film is equal to or greater than 2 mm².
(5) The method for manufacturing an organic semiconductor single crystal film according to (3) or (4) above, wherein a contact angle of the first substrate is smaller than a contact angle of the organic semiconductor single crystal film, and the difference in the contact angles between the first substrate and the organic semiconductor single crystal film is 80 degrees or more.
(6) The method for manufacturing an organic semiconductor single crystal film according to any one of (3) to (5) above, wherein the applying water to the interface between the first substrate and the organic semiconductor single crystal film comprises immersing the first substrate on which the organic semiconductor single crystal film is formed in water.
(7) A method for manufacturing an organic semiconductor device, comprising disposing the organic semiconductor single crystal film manufactured by the method for manufacturing an organic semiconductor single crystal film according to any one of (3) to (6) above on a second substrate, wherein at least a part of a surface of the second substrate in contact with the organic semiconductor single crystal film is hydrophobic, solvent soluble, non-heat resistant, or a combination thereof.
(8) The method for manufacturing an organic semiconductor device according to (7) above, wherein the disposing the organic semiconductor single crystal film on the second substrate comprises disposing the second substrate so as to be in contact with the organic semiconductor single crystal film formed on the first substrate while applying water to the interface between the first substrate and the organic semiconductor single crystal film to separate the organic semiconductor single crystal film from the first substrate and dispose the organic semiconductor single crystal film on the second substrate.
(9) The method for manufacturing an organic semiconductor device according to (7) or (8) above, wherein the at least a portion of the surface of the second substrate in contact with the organic semiconductor single crystal film has at least one of a concave portion, a convex portion, an uneven portion, and an electrode.

### [ADVANTAGEOUS EFFECTS OF INVENTION]

According to the present disclosure, it is possible to obtain an organic semiconductor single crystal film that can be disposed on a desired substrate and has a thickness thinner than that of a conventional film.

### BRIEF DESCRIPTION OF DRAWINGS

FIG. 1 is a cross-sectional schematic drawing of an organic semiconductor single crystal film formed on a mica substrate.
FIG. 2 is a schematic drawing showing a state in which a hydrophilic substrate on which an organic semiconductor single crystal film is formed is immersed in water and the organic semiconductor single crystal film floats on a water surface.
FIG. 3 is an electron diffraction pattern of a resulting organic semiconductor single crystal film obtained by transmission electron microscopy (TEM) observation.
FIG. 4 is a schematic drawing illustrating a state of transferring an organic semiconductor single crystal film formed on a mica substrate onto a CYTOP (registered trademark)/SiO₂/Si substrate.
FIG. 5 is a polarized light microscopic image of an organic semiconductor single crystal film disposed on CYTOP (registered trademark) observed from the surface.
FIG. 6 is a cross-sectional schematic drawing of an organic semiconductor single crystal film and an Au electrode disposed on a CYTOP (registered trademark)/SiO₂/Si substrate.
FIG. 7 is a polarized light microscopic image of a fabricated BGTC type OFET observed from the top surface.
FIG. 8 is a graph of transfer characteristics showing the relationship between gate voltage and drain current in the saturation region.
FIG. 9 is a graph of transfer characteristics showing the relationship between gate voltage and drain current in the linear region.
FIG. 10 is a graph of output characteristics showing the relationship between drain voltage and drain current depending on the gate voltage.
FIG. 11 is a schematic drawing illustrating a state in which an organic semiconductor single crystal film formed on a mica substrate is transferred onto a parylene/SiO₂/Si substrate.
FIG. 12 is a polarized light microscope image of an organic semiconductor single crystal film disposed on parylene, observed from the surface.
FIG. 13 is a schematic drawing showing a state in which an organic semiconductor single crystal film formed on a mica substrate is transferred onto a PDMS/PET substrate having Au electrodes.
FIG. 14 is a polarized light microscopic image of an organic semiconductor single crystal film disposed on an Au and a PDMS/PET substrate observed from the surface.
FIG. 15 is a schematic drawing showing a state in which an organic semiconductor single crystal film formed on an Eagle glass substrate is transferred onto a parylene/polyimide substrate with Au electrodes.
FIG. 16 is a schematic cross-sectional drawing of an organic semiconducting single crystal film disposed on a parylene (diX-SR(registered trademark))/polyimide (PI) substrate with Au electrodes modified with PFBT.
FIG. 17 is a schematic cross-sectional drawing of a top-gate bottom-contact (TGBC)-type organic field-effect transistor (OFET).
FIG. 18 is a polarized light microscopic image of a manufactured TGBC type OFET observed from the top surface.
FIG. 19 is a graph showing the relationship between gate voltage and drain current in the saturation region.
FIG. 20 is a graph showing the relationship between gate voltage and drain current in the linear region.
FIG. 21 is a graph showing the relationship between drain voltage and drain current depending on the gate voltage.
FIG. 22 is a schematic drawing illustrating a state in which an organic semiconducting single crystal film formed on an Eagle glass is transferred onto a CYTOP (registered trademark)/SiO₂/Si substrate having Au electrodes modified by PFBT.
FIG. 23 is a schematic cross-sectional drawing of an organic semiconductor single crystal film disposed on a CYTOP (registered trademark)/SiO₂/Si substrate having Au electrodes modified with PFBT.
FIG. 24 is a cross-sectional schematic drawing of a top-gate bottom-contact (TGBC) type organic field-effect transistor (OFET).
FIG. 25 is a polarized light microscopic image observed from a top surface of a manufactured TGBC type OFET.
FIG. 26 is a graph showing the relationship between gate voltage and drain current in the saturation region.
FIG. 27 is a graph showing the relationship between gate voltage and drain current in the linear region.
FIG. 28 is a graph showing the relationship between drain voltage and drain current depending on gate voltage.
FIG. 29 is a confocal laser microscopic image of an organic semiconductor single crystal film, which is observed from the surface, formed on an Eagle glass substrate and transferred onto a CYTOP (registered trademark)/SiO₂/Si substrate.
FIG. 30 is a result obtained from a single crystal X-ray diffraction experiment of the obtained organic semiconductor single crystal film.

### DESCRIPTION OF EMBODIMENTS

The present disclosure is directed to an organic semiconductor device comprising: a substrate; and an organic semiconductor single crystal film on the substrate, wherein an average film thickness of the organic semiconductor single crystal film is 2 to 100 nm, and at least a portion of a surface of the substrate in contact with the organic semiconductor single crystal film is hydrophobic, solvent soluble, non-heat resistant, or a combination thereof.

The average film thickness of the organic semiconductor single crystal film in the organic semiconductor device of the present disclosure is 2 to 100 nm, preferably 4 to 20 nm. By having the average film thickness of the organic semiconductor single crystal film in the range, good device characteristics can be obtained. The average film thickness of the organic semiconductor single crystal film can be measured using a stylus type surface profile measuring instrument or an atomic force microscope.

The organic semiconductor single crystal film in the organic semiconductor device of the present disclosure preferably has 1 molecular layer to 50 molecular layers, more preferably 1 molecular layer to 10 molecular layers, and still more preferably 1 molecular layer to 5 molecular layers in the thickness direction. The organic semiconductor single crystal film in the organic semiconductor device of the present disclosure most preferably has one molecular layer, but may have two or more molecular layers in the thickness direction. The number of molecular layers of the organic semiconductor single crystal film can be measured by an atomic force microscope.

The thickness of one molecular layer of the organic semiconductor single crystal film in the organic semiconductor device of the present disclosure is preferably 2 to 6 nm, more preferably 2 to 4 nm. The thickness of one molecular layer of the organic semiconductor single crystal film can be measured by combining with single crystal X-ray structure analysis and atomic force microscope observation.

The area of the organic semiconductor single crystal film in the organic semiconductor device of the present disclosure is preferably 2 mm² or more, more preferably 10 mm² or more, even more preferably 100 mm² or more, even more preferably 1000 mm² or more, and even more preferably 10000 mm² or more. The upper limit of the area of the organic semiconductor single crystal film is not particularly limited, and may be limited by the size of the manufacturing facility and may be, for example, 10m². Conventionally, when a vapor phase growth method is used, only an organic semiconductor single crystal film having an area of at most about 1 mm² could be obtained, whereas the organic semiconductor device of the present disclosure can have a large area as described above.

The organic semiconductor single crystal film in the organic semiconductor device of the present disclosure is composed of a single domain or multi-domain, and preferably is composed of a single domain. The domain of the organic semiconductor single crystal film can be measured by single crystal X-ray diffraction. The organic semiconductor single crystal film of the organic semiconductor device of the present disclosure preferably has a single domain with a contiguous area of 0.005 mm² or more, more preferably 0.5 mm² or more, and even more preferably 2.0 mm² or more.

The organic semiconductor single crystal film in the organic semiconductor device of the present disclosure exhibits a mobility of preferably 0.5 cm²/V•s or more, more favorably 3.0 cm²/V•s or more, more favorably 5.0cm²/V•s or more, more favorably 7.5 cm²/V•s or more, and more favorably 10 cm²/V•s or more. The mobility of the organic semiconductor single crystal film can be calculated from the measurement results of the organic field effect transistor.

In the organic semiconductor device of the present disclosure, at least a portion of the surface of the substrate in contact with the organic semiconductor single crystal film has characteristics of hydrophobicity, solvent solubility, non-heat resistance, or a combination thereof. Preferably, the entire surface of the substrate in contact with the organic semiconductor single crystal film has the characteristics of hydrophobicity, solvent solubility, non-heat resistance, or a combination thereof, and more preferably, the entire substrate has the characteristics of hydrophobicity, solvent solubility, non-heat resistance, or a combination thereof.

In the present application, hydrophobicity may have preferably a contact angle of 80 degrees or more, more preferably a contact angle of 90 degrees or more, still more preferably 100 degrees or more, still more preferably 110 degrees or more, and still more preferably 150 degrees or more.

In the organic semiconductor device of the present disclosure, at least a part of the surface of the substrate in contact with the organic semiconductor single crystal film, preferably the entire surface of the substrate in contact with the organic semiconductor single crystal film, more preferably the entire substrate exhibits hydrophobicity in the above preferable range, whereby when a device is manufactured using an organic semiconductor single crystal film disposed on the hydrophobic substrate, moisture (adsorbed molecules) that can be attached to the substrate can be reduced or eliminated, and a device having favorable characteristics without influence of moisture can be manufactured.

Examples of the hydrophobic substrate include parylene (contact angle: about 80 to 90 degrees), CYTOP (registered trademark) (contact angle: 110 degrees) which is a fluorine-based polymer, and the like.

In the present application, the solvent soluble means substantially dissolving, decomposing, or swelling in an organic solvent, and means substantially dissolving, decomposing, or swelling with respect to an organic solvent conventionally used in a coating method, for example, toluene, dichlorobenzene, or the like.

In the organic semiconductor device of the present disclosure, at least a part of the surface of the substrate in contact with the organic semiconductor single crystal film, preferably the entire surface of the substrate in contact with the organic semiconductor single crystal film, more preferably the entire substrate may be soluble in a solvent. Therefore, at least a part of the surface of the substrate in contact with the organic semiconductor single crystal film, preferably the entire surface of the substrate in contact with the organic semiconductor single crystal film, more preferably the entire substrate may be a p-type organic semiconductor film or an n-type organic semiconductor film, or may be a laminate comprising a p-type organic semiconductor film and an n-type organic semiconductor film. Therefore, the substrate in the electronic device of the present disclosure may include a pn junction structure, a pnp junction structure, or an npn junction structure formed of an organic semiconductor film.

In the present application, the non-heat resistance preferably means that the glass transition point is 90 ° C or less, or sublimation, melting, or decomposition occurs at 90 ° C or less, and more preferably means that the glass transition point is 120 ° C or less, or sublimation, melting, or decomposition occurs at 120 ° C or less.

In the organic semiconductor device of the present disclosure, at least a part of the surface of the substrate in contact with the organic semiconductor single crystal film, preferably the entire surface of the substrate in contact with the organic semiconductor single crystal film, more preferably the entire substrate may be non-heat resistant. Therefore, at least a part of the surface of the substrate in contact with the organic semiconductor single crystal film, preferably the entire surface of the substrate in contact with the organic semiconductor single crystal film, more preferably the entire substrate, may be a substrate having an electrode film of Au or the like modified with a self-assembled monolayer (SAM: self-assembled monolayer), such as pentafluorobenzene thiol (PFBT), for example. The organic semiconductor single crystal film can be disposed on such a modifying material having low heat resistance, such as PFBT or the like.

The type of the organic semiconductor constituting the organic semiconductor single crystal film in the organic semiconductor device of the present disclosure is not particularly limited, and for example, a polycyclic aromatic compound of four or more rings, or a polycyclic compound of four or more rings formed of one or more unsaturated five-membered heterocyclic compounds and a plurality of benzene rings can be used.

The organic semiconductor constituting the organic semiconductor single-crystal film in the organic semiconductor device of the present disclosure is preferably a material having a high self-aggregation ability, such as a p-type organic semiconductor Cn-DNBDT-NW of the following formula (1) exhibiting a high mobility. 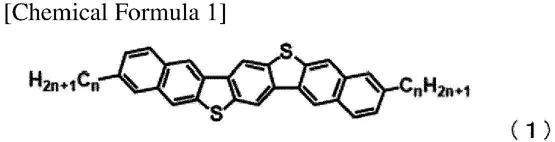 In formula (1), n may be 1 to 14. The self-aggregation ability refers to a tendency of molecules to spontaneously aggregate and crystallize as the molecules precipitate from a solvent.

Other examples of the organic semiconductor constituting the organic semiconductor single crystal film in the organic semiconductor device of the present disclosure are shown in the following formulas (2) to (6).

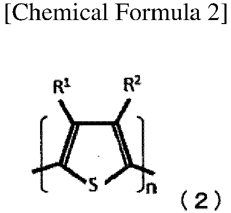

In the polythiophene semiconductor represented by Formula (2), R1 and R2 are each independently a hydrogen atom or an alkyl group having 4 to 10 carbon atoms. The alkyl group may comprise a heteroatom (typically selected from an oxygen atom and a sulfur atom). In addition, R1 and R2 together can form a ring. For reasons of self-aggregation ability, preferably, R1 and R2 are each independently a hydrogen atom or an alkyl group having 5 to 8 carbon atoms. More preferably, each of R1 and R2 is independently a hydrogen atom or a hexyl group.

The n represents an integer of 5 to 100. The n indicates the average number of thiophene monomer units in the polythiophene semiconductor, i.e., the length of the polythiophene chain. From the viewpoint of forming the single crystal film, the n is preferably 50 or less.

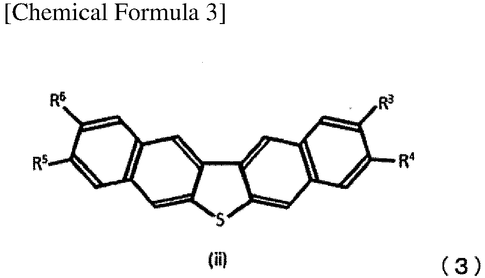

In Formula (3), each of R3, R4, R5 and R6 is independently a hydrogen atom or an alkyl group having 1 to 14 carbon atoms. The alkyl group may comprise a heteroatom (typically selected from an oxygen atom and a sulfur atom), and the hydrogen atom in the alkyl group may be substituted with a substituent, such as a halogen atom. For reasons of self-aggregation ability, R4=R5 is preferred, and R3=R6 is preferred. From the viewpoint of solubility, preferably, R4 and R5 are hydrogen atoms, and R3 and R6 are each independently an alkyl group having 1 to 14 carbon atoms, or R3 and R6 are hydrogen atoms, and R4 and R5 are each independently an alkyl group having 1 to 14 carbon atoms. More preferably, R3 and R6 are hydrogen atoms, and R4 and R5 are each independently an alkyl group having 1 to 14 carbon atoms. For reasons of self-aggregation ability, the carbon number of the alkyl group is preferably from 4 to 12, more preferably from 6 to 10.

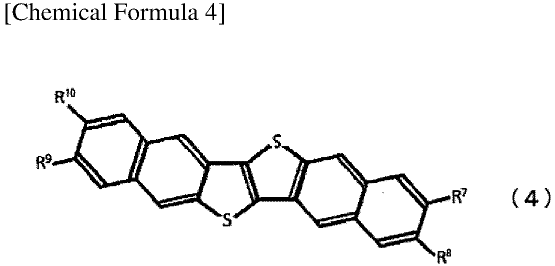

In Formula (4), each of R7, R8, R9 and R10 is independently a hydrogen atom or an alkyl group having 1 to 14 carbon atoms. The alkyl group may comprise a heteroatom (typically selected from an oxygen atom and a sulfur atom), and the hydrogen atom in the alkyl group may be substituted with a substituent, such as a halogen atom. For reasons of self-aggregation ability, R7=R9 is preferred, and R8=R10 is preferred. From the viewpoint of solubility, preferably, R7 and R9 are hydrogen atoms, and R8 and R10 are each independently an alkyl group having 1 to 14 carbon atoms, or R8 and R10 are hydrogen atoms, and R7 and R9 are each independently an alkyl group having 1 to 14 carbon atoms. More preferably, R8 and R10 are hydrogen atoms, and R7 and R9 are each independently an alkyl group having 1 to 14 carbon atoms. For reasons of self-aggregation ability, the carbon number of the alkyl group is preferably from 6 to 13, more preferably from 8 to 10.

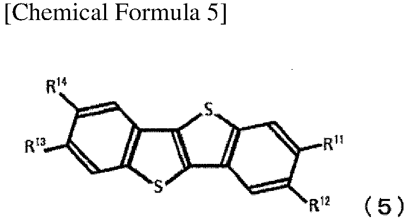

In Formula (5), each of R11, R12, R13 and R14 is independently a hydrogen atom or an alkyl group having 1 to 14 carbon atoms. The alkyl group may comprise a heteroatom (typically selected from an oxygen atom and a sulfur atom), and the hydrogen atom in the alkyl group may be substituted with a substituent, such as a halogen atom. For reasons of self-aggregation ability, R11=R13 is preferred, and R12=R14 is preferred. From the viewpoint of solubility, preferably, R11 and R13 are hydrogen atoms, and R12 and R14 are each independently an alkyl group having 1 to 14 carbon atoms, or R12 and R14 are hydrogen atoms, and R11 and R13 are each independently an alkyl group having 1 to 14 carbon atoms. More preferably, R12 and R14 are hydrogen atoms, and R11 and R13 are each independently an alkyl group having 1 to 14 carbon atoms. For reasons of self-aggregation ability, the number of carbon atoms of the alkyl group is preferably from 5 to 12, more preferably from 8 to 10.

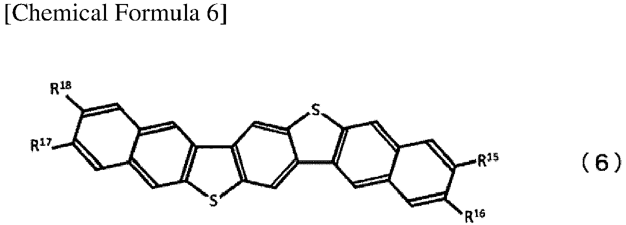

In formula (6), R15, R16, R17 and R18 are each independently a hydrogen atom or an alkyl group having 1 to 14 carbon atoms. The alkyl group may comprise a heteroatom (typically selected from an oxygen atom and a sulfur atom), and the hydrogen atom in the alkyl group may be substituted with a substituent, such as a halogen atom. For reasons of self-aggregation ability, R15=R17 is preferred, and R16=R18 is preferred. From the viewpoint of solubility, preferably, R16 and R18 are hydrogen atoms, and R15 and R17 are each independently an alkyl group having 1 to 14 carbon atoms, or R15 and R17 are hydrogen atoms, and R16 and R18 are each independently an alkyl group having 1 to 14 carbon atoms. More preferably, R16 and R18 are hydrogen atoms, and R15 and R17 are each independently an alkyl group having 1 to 14 carbon atoms. For reasons of self-aggregation ability, the number of carbon atoms of the alkyl group is preferably from 5 to 12, more preferably from 8 to 10.

Yet another examples of the organic semiconductor constituting the organic semiconductor single crystal film in the organic semiconductor device of the present disclosure are shown in the following formulas (7) to (15). In Formula (7) to Formula (15), R may be linear alkyl, branched alkyl, fluorinated linear/branched alkyl, triisopropylsilylethynyl, phenyl, or the like.

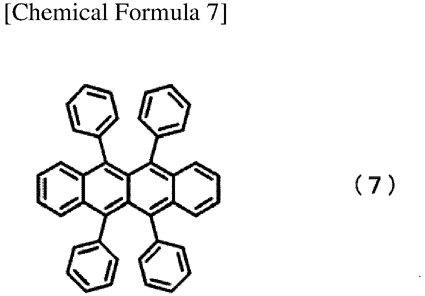

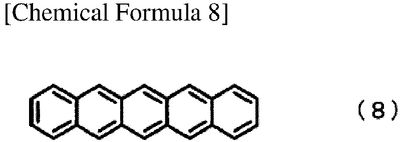

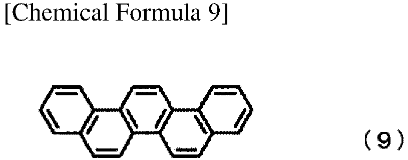

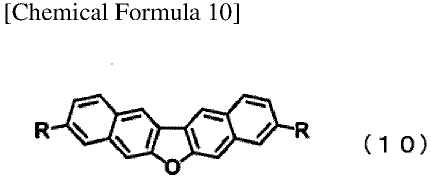

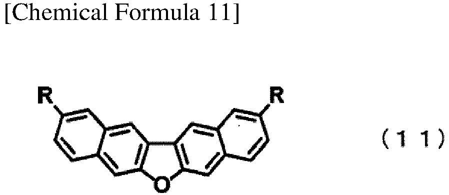

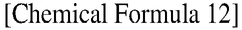

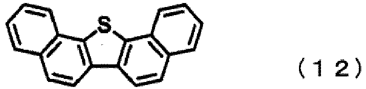

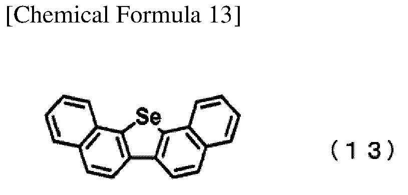

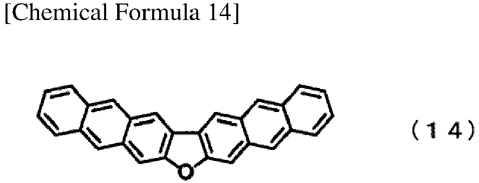

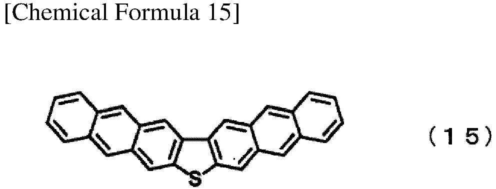

The organic semiconductor single crystal film can be confirmed to be single crystal by observing the organic semiconductor single crystal film with a transmission electron microscope (TEM).

The organic semiconductor device of the present disclosure can be an organic EL (electroluminescence) element, an organic solar cell element, an organic photoelectric conversion element, an organic transistor element, an organic field effect transistor element, or the like.

The present disclosure is also directed to a method for manufacturing an organic semiconductor single crystal film, comprising: forming an organic semiconductor single crystal film having an average film thickness of 2 to 100 nm on a hydrophilic and non-water-soluble first substrate using a coating method, and separating the organic semiconductor single crystal film from the first substrate by applying water to an interface between the first substrate and the organic semiconductor single crystal film.

According to the method for manufacturing an organic semiconductor single crystal film of the present disclosure, it is possible to provide an organic semiconductor single crystal film that can be disposed on a desired substrate and has a thickness thinner than that of a conventional film.

In the method for manufacturing an organic semiconductor single crystal film of the present disclosure, an organic semiconductor single crystal film having an average film thickness of 2 to 100 nm is formed on a hydrophilic and non-water-soluble first substrate by a coating method. The coating method is a method in which an organic semiconductor is dissolved in an organic solvent to prepare an organic semiconductor solution, the organic semiconductor solution is applied on a substrate, and the organic solvent is evaporated to form a film. As the organic solvent, an organic solvent conventionally used in a coating method can be used, and for example, toluene, dichlorobenzene, or the like can be used.

In the method for manufacturing an organic semiconductor single crystal film of the present disclosure, a method conventionally used can be used as a coating method, and for example, an edge casting method, a continuous edge casting method, a drop casting method, a spin coating method, a printing method (ink jet method or gravure printing method), a dispenser method, a spray method, a dip coating method, a die coater method, a roll coater method, a bar coater method, a blade coating method, or the like can be used.

The first substrate is a hydrophilic substrate having a contact angle of water of preferably 20 degrees or less, more preferably 10 degrees or less. The first substrate is non-water-soluble and can be, for example, mica or glass. Since the first substrate is non-water-soluble, when water is applied to the interface between the first substrate and the organic semiconductor single crystal film, components of the first substrate are not eluted and do not adhere to or react with the organic semiconductor single crystal film, so that a high-purity organic semiconductor single crystal film can be obtained. Further, when applying water to the interface between the first substrate and the organic semiconductor single crystal film, in order to maintain the shape of the first substrate without collapsing, it is possible to separate the organic semiconductor single crystal film from the first substrate without distorting the shape of the organic semiconductor single crystal film. The non-water-soluble means that it does not substantially dissolve, decompose, or swell in water. The glass is preferably subjected to a hydrophilic treatment on the surface by UV-ozone treatment or a hydrophilic coating material or the like.

Water is applied to the interface between the first substrate and the organic semiconductor single crystal film to separate the organic semiconductor single crystal film from the first substrate. Since a molecule of the organic semiconductor single crystal film applied to the first substrate is hydrophobic, water enters between the hydrophilic first substrate and the molecule of the hydrophobic organic semiconductor single crystal film, and the organic semiconductor single crystal film can be separated from the first substrate.

The water contact angle of the hydrophilic first substrate is smaller than the water contact angle of the hydrophobic organic semiconductor single crystal film, and the difference in the water contact angle between the first substrate and the organic semiconductor single crystal film is preferably 80 degrees or more, more preferably 90 degrees or more. The contact angle of the organic semiconductor single crystal film is preferably 100 to 120 degrees. When the difference in the contact angle between the hydrophilic first substrate and the hydrophobic organic semiconductor single crystal film is within the preferable range, the organic semiconductor single crystal film can be more stably peeled off from the first substrate.

The method of applying water to the interface between the first substrate and the organic semiconductor single crystal film is not particularly limited, and may include immersing the first substrate on which the organic semiconductor single crystal film is formed in water, dropping a dropper of water at the interface between the first substrate and the organic semiconductor single crystal film, or the like.

The method of applying water to the interface between the first substrate and the organic semiconductor single crystal film preferably comprises immersing the first substrate on which the organic semiconductor single crystal film is formed in water. By immersing the first substrate on which the organic semiconductor single crystal film is formed in water, the organic semiconductor single crystal film is separated from the first substrate in water, and an organic semiconductor single crystal film which is self-standing in water can be obtained. The self-standing organic semiconductor single crystal film can be disposed on any substrate, such as a hydrophobic substrate, a solvent-soluble substrate, a non-heat-resistant substrate, or a substrate having a concave portion, a convex portion, an uneven portion, or an electrode, or a mesh-shaped or grid-shaped substrate in the organic semiconductor device described above.

With respect to the average film thickness, molecular layer, area, domain, and mobility of the organic semiconductor single crystal film obtained by the method for manufacturing the organic semiconductor single crystal film of the present disclosure, the contents relating to the organic semiconductor single crystal film in the organic semiconductor device described above can be applied.

The present disclosure is also directed to a method for manufacturing an organic semiconductor device, comprising disposing an organic semiconductor single crystal film manufactured by the method for manufacturing an organic semiconductor single crystal film described above on a second substrate, wherein at least a portion of a surface of the second substrate in contact with the organic semiconductor single crystal film is hydrophobic, solvent soluble, non-heat resistant, or a combination thereof.

In the method for manufacturing an organic semiconductor device of the present disclosure, the organic semiconductor single crystal film separated from the first substrate by the method for manufacturing the organic semiconductor single crystal film described above is disposed on the second substrate.

At least a portion of the surface of the second substrate on which the organic semiconductor single crystal film is disposed in contact with the organic semiconductor single crystal film has characteristics of hydrophobicity, solvent solubility, non-heat resistance, or a combination thereof. Preferably, the entire surface of the second substrate in contact with the organic semiconductor single crystal film has the characteristics of hydrophobicity, solvent solubility, non-heat resistance, or a combination thereof, and more preferably, the entire second substrate has the characteristics of hydrophobicity, solvent solubility, non-heat resistance, or a combination thereof.

As for the contents relating to the hydrophobicity, the solvent solubility, and the non-heat resistance of the second substrate, the contents described in terms of the hydrophobicity, the solvent solubility, and the non-heat resistance of the substrate of the organic semiconductor device described above can be applied.

The disposing the organic semiconductor single crystal film on the second substrate preferably comprises separating the organic semiconductor single crystal film from the first substrate by applying water to the interface between the first substrate and the organic semiconductor single crystal film while disposing the second substrate so as to be in contact with the organic semiconductor single crystal film formed on the first substrate, and disposing the organic semiconductor single crystal film on the second substrate. By thus separating the organic semiconductor single crystal film from the first substrate while disposing the second substrate so as to contact the organic semiconductor single crystal film, it is possible to transfer the organic semiconductor single crystal film directly from the first substrate to the second substrate.

Alternatively, the disposing the organic semiconductor single crystal film on the second substrate preferably comprises immersing the first substrate having the organic semiconductor single crystal film formed thereon in water, separating the organic semiconductor single crystal film from the first substrate in water to obtain a self-standing organic semiconductor single crystal film, and disposing the organic semiconductor single crystal film on the second substrate in water. Thus, in water, by disposing a free-standing organic semiconductor single crystal film on the second substrate, it is possible to easily transfer the organic semiconductor single crystal film from the first substrate to the second substrate.

More preferably, the disposing the organic semiconductor single crystal film on the second substrate comprises immersing the first substrate, the organic semiconductor single crystal film, and the second substrate in water while disposing the second substrate so as to be in contact with the organic semiconductor single crystal film formed on the first substrate, and transferring the organic semiconductor single crystal film from the first substrate to the second substrate. In this manner, by separating the organic semiconductor single crystal film from the first substrate while disposing the second substrate in contact with the organic semiconductor single crystal film in water, the organic semiconductor single crystal film can be more easily transferred from the first substrate to the second substrate.

At least a portion of the surface in contact with the organic semiconductor single crystal film of the second substrate may have at least one of a concave portion, a convex portion, an uneven portion, and an electrode.

Conventionally, when fabricating a transistor having a top gate structure by a coating method, it is necessary to apply an organic semiconductor on a substrate in which an electrode is arranged, due to the difference in surface energy between the electrode and the substrate, and the difference in step between the convex portion of the electrode and the concave portion of the substrate, the crystallinity and thickness of the organic semiconductor cannot be uniformly formed, making it difficult to obtain good transistor characteristics.

According to the method for manufacturing an organic semiconductor of the present disclosure, even if the second substrate has an electrode, the organic semiconductor single crystal film peeled off from the first substrate is brought into contact with the second substrate, whereby the organic semiconductor single crystal film can be disposed with a uniform thickness on the second substrate having the electrode.

The second substrate may have a concave portion, a convex portion, or an uneven portion, attributable to the electrode or not attributable to the electrode. The concave portion, convex portion, or an uneven portion can be rectangular in shape, curved in shape, or a combination thereof. The depth of the concave portion, the height of the convex portion, and the depth of the uneven portion (the distance in the thickness direction of the substrate between the lowest portion of the concave portion and the highest portion of the convex portion) on the second substrate are each preferably greater than 0 nm and equal to or less than 30 nm.

### EXAMPLES

### (Example 1)

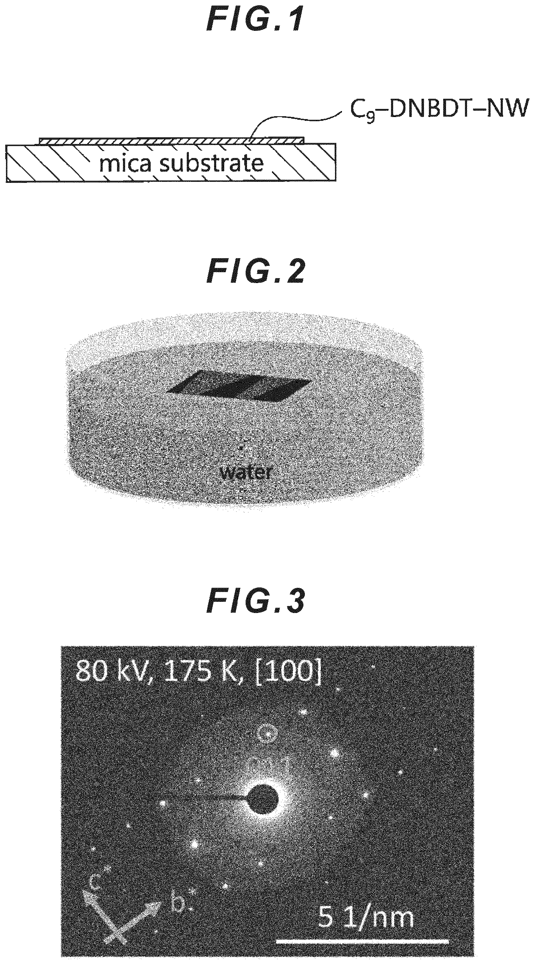

A natural mica substrate was prepared as a hydrophilic substrate. As an organic semiconductor, a powder of p-type organic semiconductor C₉-DNBDT-NW of the following formula (16), which shows high mobility, was prepared. 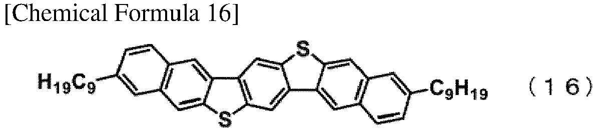 3-chlorothiophene was used as a solvent, and the organic semiconductor powder was dissolved in the solvent to prepare an organic semiconductor solution. The prepared organic semiconductor solution was coated on the mica substrate heated to 100° C. by the continuous edge casting method, and an organic semiconductor single crystal film having an average thickness of 12 nm and an area of 200 mm² as shown in FIG. 1 was formed on the substrate. The water contact angle on the surface of the organic semiconductor single crystal film was 108 degrees. FIG. 1 is a cross-sectional schematic drawing of the organic semiconductor single crystal film formed on the mica substrate.

As shown in FIG. 2, the hydrophilic substrate on which the organic semiconductor single crystal film was formed was immersed in water, and the organic semiconductor single crystal film was peeled off from the hydrophilic substrate. The organic semiconductor single crystal film was in a free standing state at the water surface. The free standing state at the water surface means that the organic semiconductor single crystal film is floating on the water surface while maintaining the crystal structure without the supporting substrate. FIG. 2 is a schematic drawing showing a state in which a hydrophilic substrate on which an organic semiconductor single crystal film is formed is immersed in water.

FIG. 3 shows an electron diffraction pattern obtained by transmission electron microscopy (TEM) observation of the obtained organic semiconductor single crystal film. It was confirmed that the organic semiconductor single crystal film maintained single crystallinity even after the separation from the hydrophilic substrate.

### (Example 2)

In the same manner as in Example 1, an organic semiconductor single crystal film of the p-type organic semiconductor C₉-DNBDT-NW of Formula (16) was formed on a mica substrate.

As a hydrophobic substrate, a CYTOP (registered trademark)/SiO₂/Si substrate in which CYTOP (registered trademark)-809M was deposited was prepared.

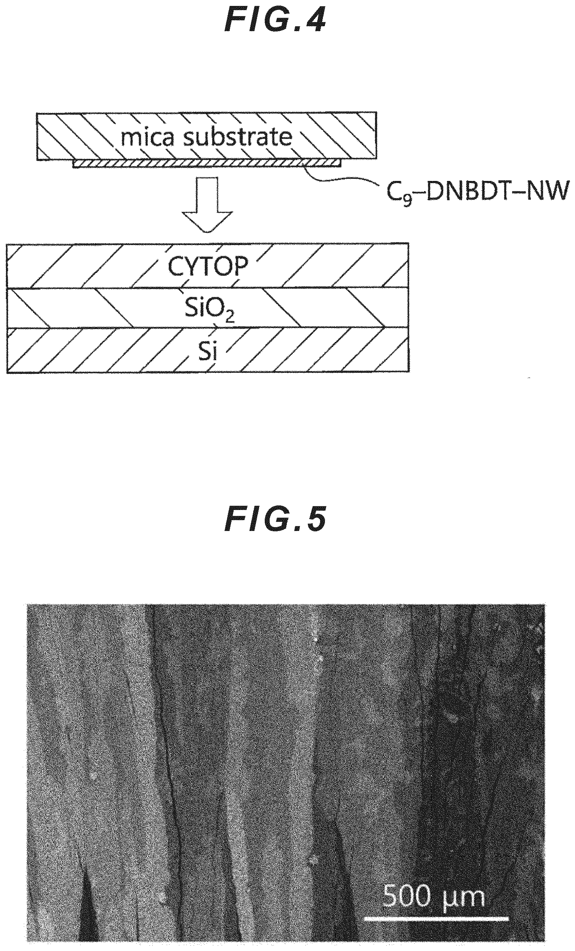

As shown in FIG. 4, the CYTOP (registered trademark)/SiO ₂/Si substrate was arranged so that CYTOP (registered trademark) was in contact with the organic semiconductor single crystal film formed on the mica substrate, water was dropped at the interface between the mica substrate and the organic semiconductor single crystal film, and the organic semiconductor single crystal film was peeled from the mica substrate and transferred onto CYTOP (registered trademark). FIG. 4 is a schematic drawing illustrating a state of transferring the organic semiconductor single crystal film formed on the mica substrate onto the CYTOP (registered trademark)/SiO₂/Si substrate. FIG. 5 shows a polarized light microscopic image obtained by observing the organic semiconductor single-crystal film disposed on the CYTOP (registered trademark) from the surface of the organic semiconductor single crystal film.

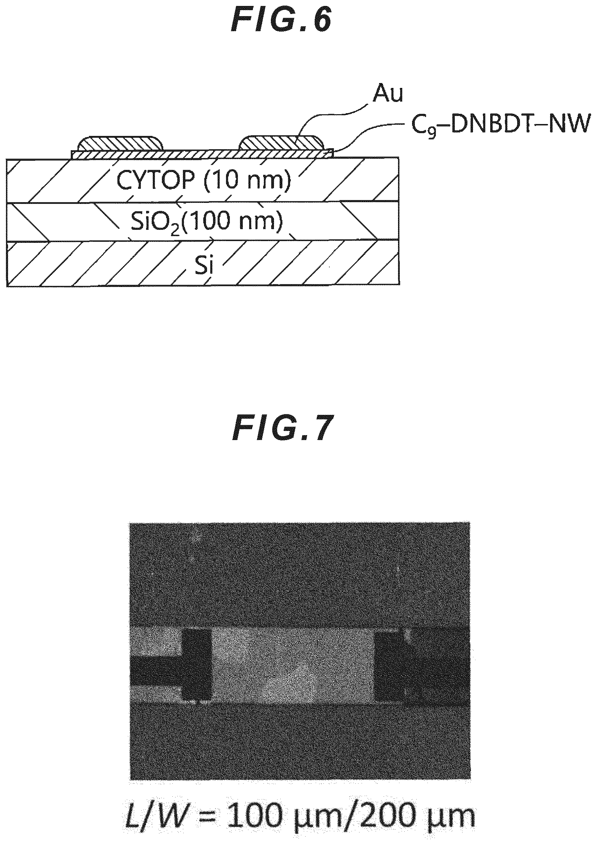

As shown in FIG. 6, Au electrodes having a length of 0.4 mm, a width of 2 mm, and a height of 40 nm were formed as an S/D electrode (source/drain electrode) on the organic semiconductor single crystal film of C₉-DNBDT-NW disposed on the CYTOP (registered trademark)/SiO₂/Si substrate by vacuum deposition using a metal mask, thereby fabricating a bottom gate top contact (BGTC) type organic field-effect transistor (OFET). FIG. 6 is a cross-sectional schematic drawing of the organic semiconductor single crystal film and the Au electrodes disposed on the CYTOP (registered trademark)/SiO₂/Si substrate. FIG. 7 shows a polarized light microscopic image observed from the top surface of the fabricated BGTC type OFET.

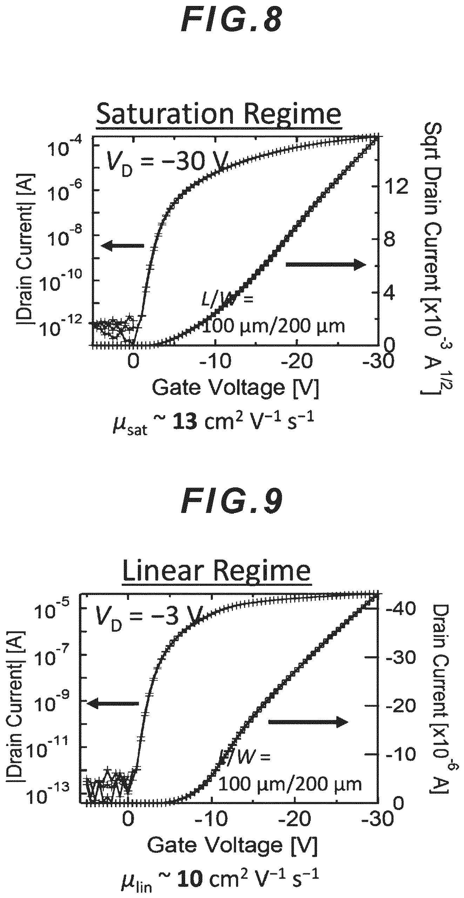

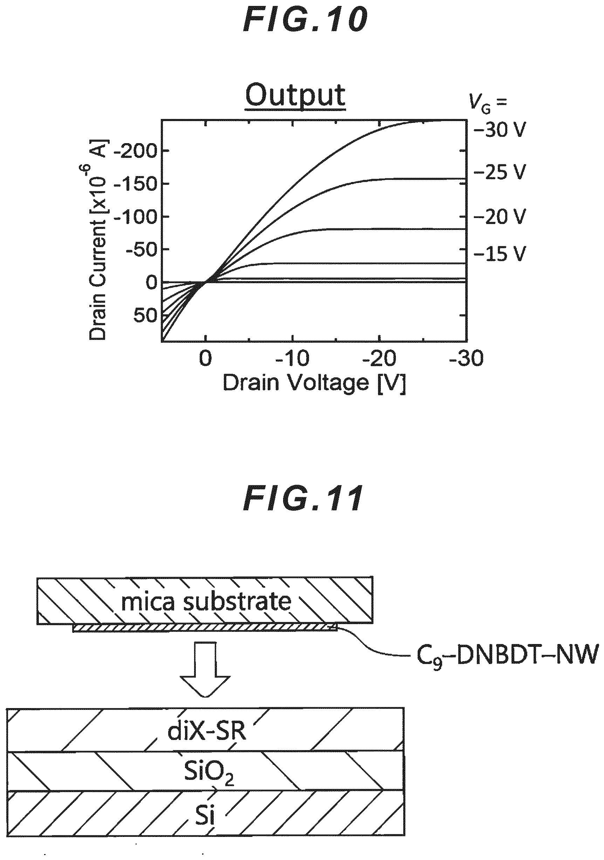

FIG. 8 shows a graph of the transfer characteristics representing the relationship between the gate voltage and the drain current in the saturation region. FIG. 9 shows a graph of the transfer characteristics representing the relationship between the gate voltage and the drain current in the linear region. FIG. 10 shows a graph of the output characteristics representing the relationship between the drain voltage and the drain current depending on the gate voltage. The mobility in the saturated region was 13 cm²/V·s, and the mobility in the linear region was 10 cm²/V·s, which were very large mobility.

### (Example 3)

In the same manner as in Example 1, an organic semiconductor single crystal film of the p-type organic semiconductor C₉-DNBDT-NW of Formula (16) was formed on a mica substrate.

As a hydrophobic substrate, a parylene/SiO ₂/Si substrate in which parylene (diX-SR (registered trademark)) was deposited was prepared.

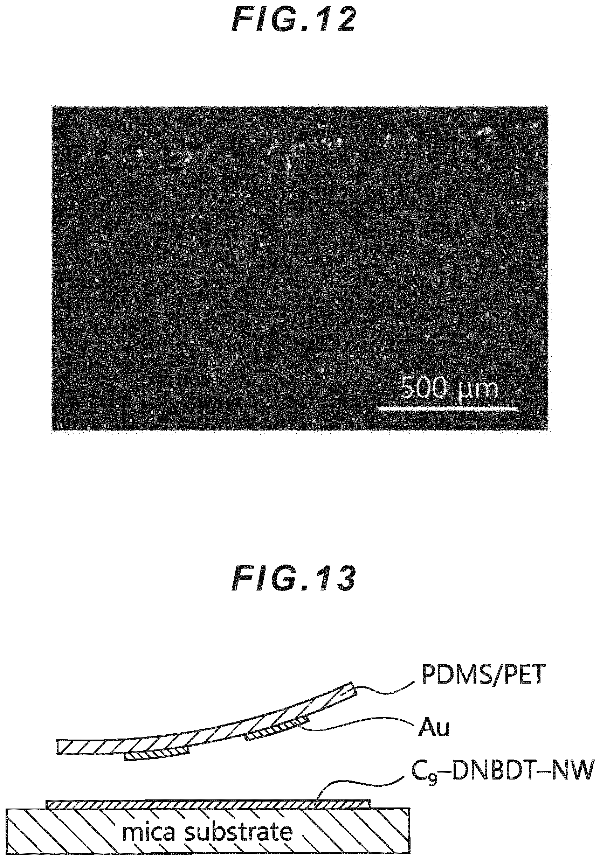

As shown in FIG. 11, the parylene/SiO/Si substrate was positioned so that the parylene was in contact with the organic semiconductor single crystal film formed on the mica substrate, water was dropped at the interface between the mica substrate and the organic semiconductor single crystal film, and the organic semiconductor single crystal film was peeled from the mica substrate and transferred onto the parylene. FIG. 11 is a schematic drawing illustrating a state of transferring the organic semiconductor single crystal film formed on the mica substrate onto the parylene/SiO/Si substrate. FIG. 12 shows a polarized light microscope image obtained by observing the organic semiconductor single crystal film disposed on the parylene from the surface of the organic semiconductor single crystal film.

### (Example 4)

In the same manner as in Example 1, an organic semiconductor single crystal film of the p-type organic semiconductor C₉-DNBDT-NW of Formula (16) was formed on a mica substrate.

As a solvent-soluble substrate, as shown in FIG. 13, a polydimethylsiloxane (PDMS)/polyethylene terephthalate (PET) substrate on which Au electrodes having a length of 0.5 mm, a width of 0.5 mm, and a height of 30 nm were formed as S/D electrodes (source/drain electrodes) by vacuum deposition using a metal mask was prepared. FIG. 13 is a schematic drawing showing a state of transferring the organic semiconductor single crystal film formed on the mica substrate onto the PDMS/PET substrate having Au electrodes.

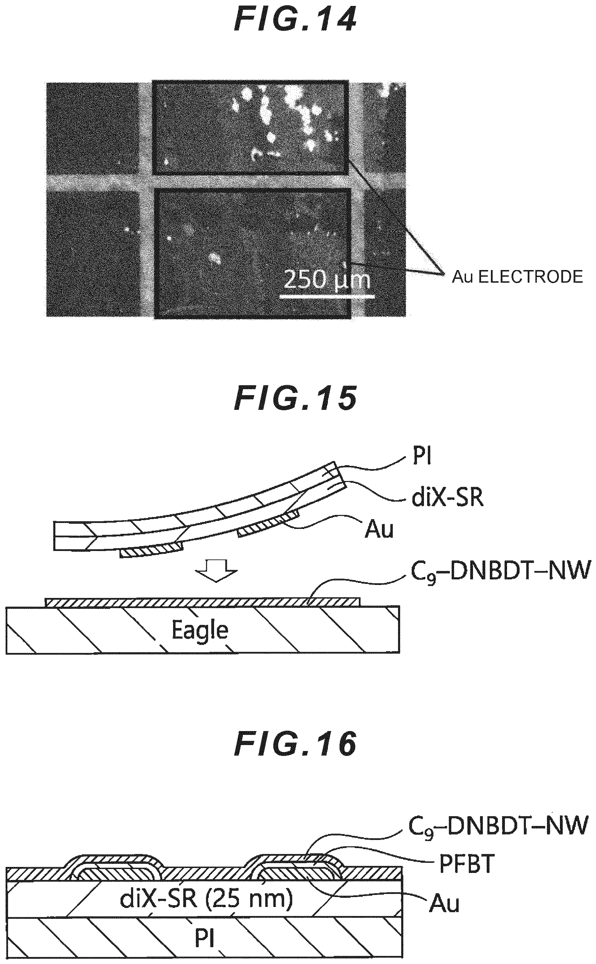

As shown in FIG. 14, the PDMS/PET substrate on which Au was vacuum-deposited as a source/drain (S/D) electrode was disposed so that the Au was in contact with the organic semiconductor single crystal film formed on the mica substrate, water was dropped at the interface between the mica substrate and the organic semiconductor single crystal film, and the organic semiconductor single crystal film was peeled off from the mica substrate and transferred onto the Au and the PDMS/PET substrate. FIG. 14 shows polarized light microscopic images obtained by observing the organic semiconductor single crystal film disposed on the Au and the PDMS/PET substrate from the surface of the organic semiconductor single crystal film.

### (Example 5)

An organic semiconductor single crystal film of the p-type organic semiconductor C₉-DNBDT-NW of Formula (16) was formed in the same manner as in Example 1 except that an Eagle glass (manufactured by Corning) subjected to UV/ozone treatment was used as an hydrophilic substrate instead of the mica substrate.

As a hydrophobic substrate, a parylene (diX-SR (registered trademark))/polyimide (PI) substrate with Au electrodes as S/D electrodes (source/drain electrodes) was prepared as shown in FIG. 15, wherein the Au electrode was formed by vacuum deposition using a metal mask, had a length of 0.4 mm, a width of 2 mm, and a height of 12 nm, and was modified with a self-assembled monolayer of pentafluorobenzenethiol (PFBT). FIG. 15 is a schematic drawing showing a state in which the organic semiconductor single crystal film formed on the Eagle glass substrate is transferred onto the parylene/polyimide substrate with the Au electrodes.

The parylene (diX-SR(registered trademark))/polyimide (PI) substrate with the Au electrodes (S/D electrode) modified by PFBT was arranged on the organic semiconductor single crystal film formed on the Eagle glass substrate so that the Au electrodes (S/D electrode) modified by PFBT were in contact with the organic semiconductor single crystal film, water was dropped at the interface between the Eagle glass substrate and the organic semiconductor single crystal film, the organic semiconductor single crystal film was separated from the Eagle glass substrate, and the organic semiconductor single crystal film was transferred onto the Au electrode and the parylene substrate modified by PFBT as shown in FIG. 16. FIG. 16 is a schematic cross-sectional drawing of the organic semiconductor single crystal film disposed on the parylene (diX-SR(registered trademark))/polyimide (PI) substrate with Au electrodes modified with PFBT.

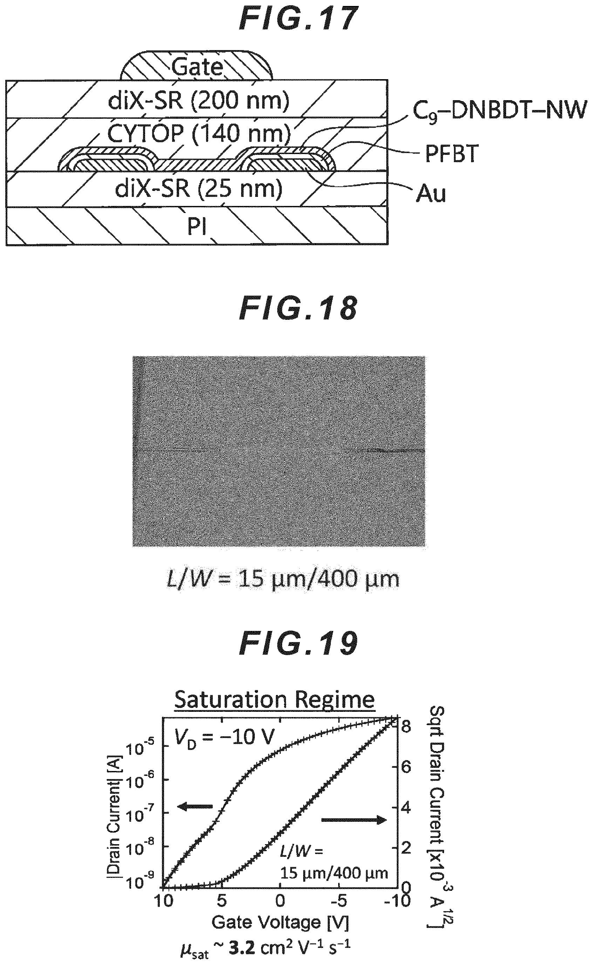

Further, as shown in FIG. 17, CYTOP (registered trademark), Parylene (diX-SR (registered trademark)), and gate electrodes were formed on C₉-DNBDT-NW of the organic semiconductor single crystal film, and a top gate bottom contact (TGBC) type organic field-effect transistor (OFET) was manufactured. FIG. 17 is a schematic cross-sectional drawing of the TGBC type OFET. FIG. 18 shows a polarized light microscopic image observed from the top surface of the manufactured TGBC type OFET.

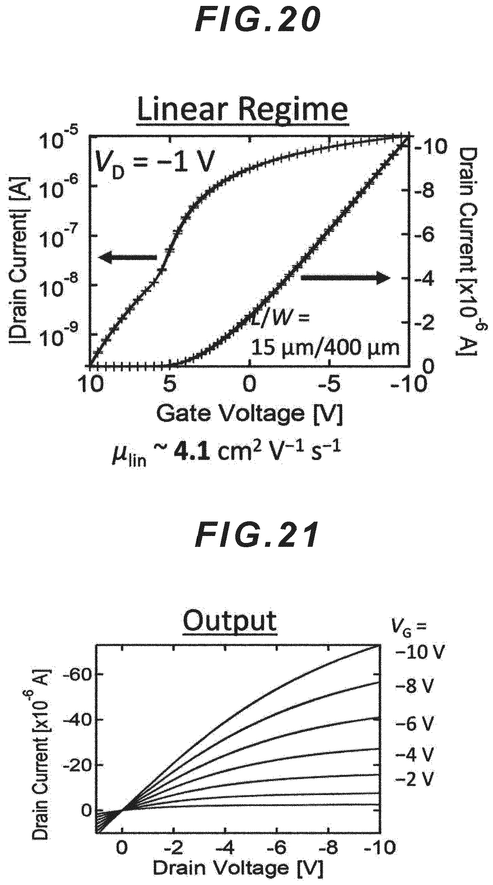

FIG. 19 shows a graph of the transfer characteristics representing the relationship between the gate voltage and the drain current in the saturation region. FIG. 20 shows a graph of the transfer characteristics representing the relationship between the gate voltage and the drain current in the linear region. FIG. 21 shows a graph of the output characteristics representing the relationship between the drain voltage and the drain current depending on the gate voltage. The mobility in the saturated region was 3.2 cm²/V•s, and the mobility in the linear region was 4.1 cm²/V•s, indicating low hysteresis and relatively high mobility.

### (Example 6)

An organic semiconductor single crystal film of the p-type organic semiconductor C₉-DNBDT-NW of Formula (16) was formed in the same manner as in Example 1 except that an Eagle glass (manufactured by Corning) subjected to UV/ozone treatment was used as the hydrophilic substrate instead of the mica substrate.

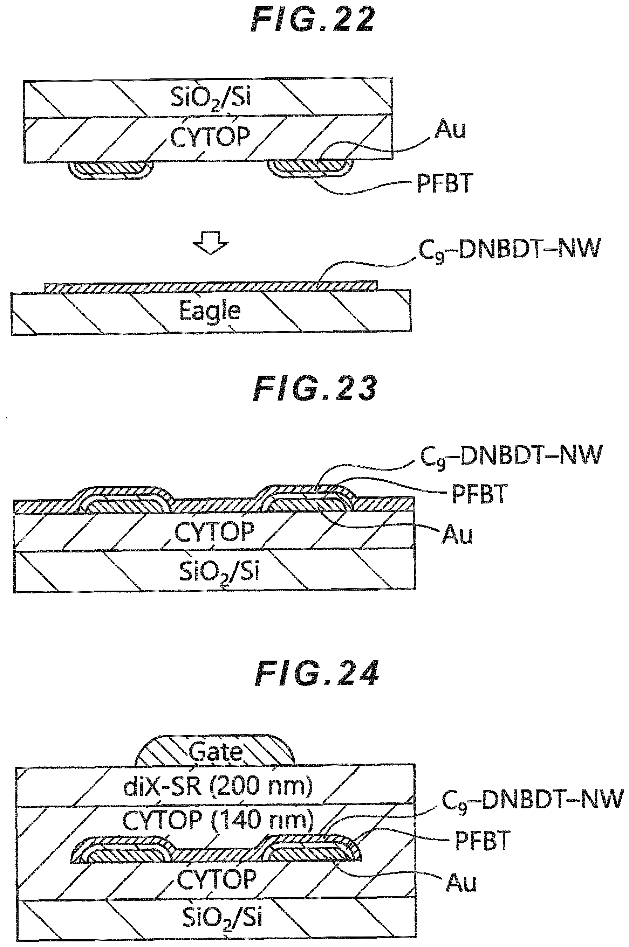

As a hydrophobic substrate, a CYTOP (registered trademark)/SiO₂/Si substrate with Au electrodes as S/D electrodes (source/drain electrodes) was prepared as shown in FIG. 22, wherein the Au electrode was formed by vacuum deposition using a metal mask, had a length of 0.4 mm, a width of 2 mm, and a height of 20 nm, and was modified with a self-assembled monolayer of pentafluorobenzenethiol (PFBT). FIG. 22 is a schematic drawing illustrating a state in which the organic semiconductor single crystal film formed on the Eagle glass substrate is transferred onto the CYTOP (registered trademark)/SiO₂/Si substrate with the Au electrodes modified by the PFBT.

The Eagle glass with PFBT-modified Au electrodes (S/D electrodes) was placed so that the Au electrodes (S/D electrodes) modified with PFBT were in contact with the organic semiconductor single crystal film deposited on the Eagle glass substrate. Water was dropped at the interface between the Eagle glass substrate and the organic semiconductor single crystal film, the organic semiconductor single crystal film was peeled off from the Eagle glass substrate, and the organic semiconductor single crystal film was transferred to the Au electrode modified with PFBT and the CYTOP (registered trademark) substrate as shown in FIG. 23. FIG. 23 is a schematic cross-sectional drawing of an organic semiconductor single-crystal film disposed on CYTOP (registered trademark)/SiO₂/Si substrates having Au electrodes modified with PFBT.

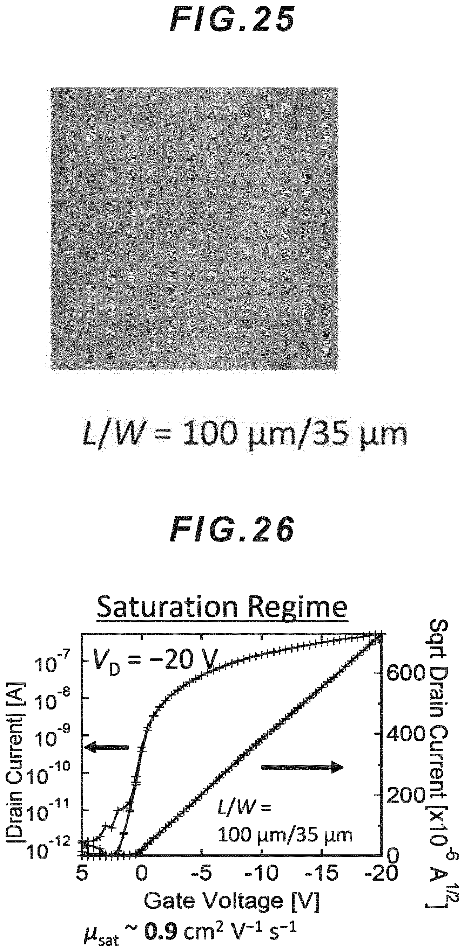

Further, as shown in FIG. 24, CYTOP (registered trademark), parylene (diX-SR (registered trademark)), and gate electrodes were formed on C₉-DNBDT-NW of the organic semiconductor single crystal film to fabricate a top gate bottom contact (TGBC) type organic field-effect transistor (OFET). FIG. 24 is a schematic cross-sectional drawing of a TGBC type OFET. FIG. 25 shows a polarized light microscopic image observed from the top surface of the fabricated TGBC type OFET.

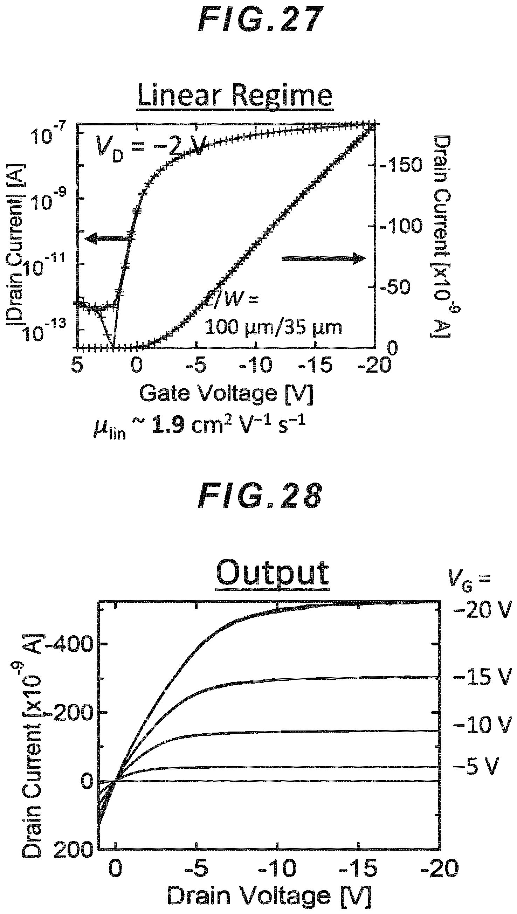

FIG. 26 shows a graph of the transfer characteristics representing the relationship between the gate voltage and the drain current in the saturation region. FIG. 27 shows a graph of the transfer characteristics representing the relationship between the gate voltage and the drain current in the linear region. FIG. 28 shows a graph of the output characteristics representing the relationship between the drain voltage and the drain current depending on the gate voltage. The mobility in the saturated region was 0.9 cm²/V s, the mobility in the linear region was 1.9 cm²/V s, and a small hysteresis and a sharp subthreshold property were shown.

### (Example 7)

An organic semiconductor single crystal film of the p-type organic semiconductor C₉-DNBDT-NW of Formula (16) was formed in the same manner as in Example 1 except that an Eagle glass (manufactured by Corning) subjected to UV/ozone treatment was used as the hydrophilic substrate instead of the mica substrate.

As a hydrophobic substrate, a CYTOP (registered trademark)/SiO₂/Si substrate in which CYTOP (registered trademark)-809M was deposited was prepared.

The CYTOP (registered trademark)/SiO₂/Si substrate was arranged so that the CYTOP (registered trademark) was in contact with the organic semiconductor single crystal film formed on the Eagle glass subjected to the UV/ozone treatment, water was dropped at the interface between the Eagle glass and the organic semiconductor single crystal film, and the organic semiconductor single crystal film of 1.7 cm² was peeled off from the Eagle glass substrate and transferred onto the CYTOP (registered trademark).

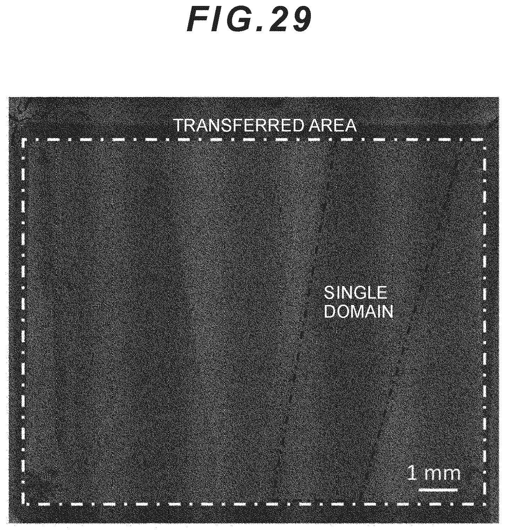

FIG. 29 shows a confocal laser microscopic image of the organic semiconductor single crystal film on the CYTOP (registered trademark)/SiO₂/Si substrate from the surface of the organic semiconductor single crystal film. The obtained organic semiconductor single crystal film had a single domain having a contiguous area of 20 mm².

Twenty-four organic field-effect transistors were fabricated using the obtained organic semiconductor single crystal film, and the mobility of the saturation region and the mobility of the linear region were measured. The average mobility of the saturation region was 10.8±1.8 cm²/V·s, and the average mobility of the linear region was 9.9±2.1 cm²/V•s.

### (Example 8)

An organic semiconductor single crystal film of the p-type organic semiconductor C₉-DNBDT-NW of Formula (16) was formed in the same manner as in Example 1 except that an Eagle glass (manufactured by Corning) subjected to UV/ozone treatment was used as the hydrophilic substrate instead of the mica substrate.

A glass substrate with a thickness of 30µm was prepared for single crystal X-ray diffraction measurement. The glass substrate was placed so as to be in contact with the organic semiconductor single crystal film formed on the Eagle glass subjected to UV and ozone treatment, and water was dropped at the interface between the organic semiconductor single crystal film and the Eagle glass substrate, and the organic semiconductor single crystal film was peeled off from the Eagle glass substrate and transferred onto the glass substrate.

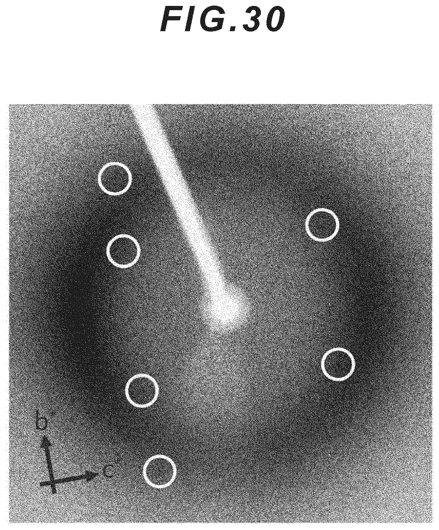

FIG. 30 shows the single crystal X-ray diffraction measurement results of the organic semiconductor single crystal film transferred on the glass substrate. c^{∗} corresponds to the crystal growth direction, and a portion surrounded by a white circle indicates a diffractive peak derived from the organic semiconductor single crystal film. Single spots were obtained from single crystal X-ray diffraction measurement, and it was found that the obtained organic semiconductor single crystal film was composed of a single domain in the area of 0.00795 mm² irradiated with X-rays.

## Claims

1. An organic semiconductor device comprising:
a substrate; and
an organic semiconductor single crystal film on the substrate,
wherein an average film thickness of the organic semiconductor single crystal film is 2 to 100nm, and
at least a portion of a surface of the substrate in contact with the organic semiconductor single crystal film is hydrophobic, solvent soluble, non-heat resistant, or a combination thereof.

2. The organic semiconductor device according to claim 1, wherein an area of the organic semiconductor single crystal film is equal to or greater than 2 mm².

3. A method for manufacturing an organic semiconductor single crystal film, comprising:
forming an organic semiconductor single crystal film having an average film thickness of 2 to 100 nm on a hydrophilic and non-water-soluble first substrate using a coating method; and
separating the organic semiconductor single crystal film from the first substrate by applying water to an interface between the first substrate and the organic semiconductor single crystal film.

4. The method for manufacturing an organic semiconductor single crystal film according to claim 3, wherein an area of the organic semiconductor single crystal film is equal to or greater than 2 mm².

5. The method for manufacturing an organic semiconductor single crystal film according to claim 3 or 4, wherein a contact angle of the first substrate is smaller than a contact angle of the organic semiconductor single crystal film, and the difference in the contact angles between the first substrate and the organic semiconductor single crystal film is 80 degrees or more.

6. The method for manufacturing an organic semiconductor single crystal film according to any one of claims 3 to 5, wherein the applying water to the interface between the first substrate and the organic semiconductor single crystal film comprises immersing the first substrate on which the organic semiconductor single crystal film is formed in water.

7. A method for manufacturing an organic semiconductor device, comprising disposing an organic semiconductor single crystal film manufactured by the method for manufacturing an organic semiconductor single crystal film according to any one of claims 3 to 6 on a second substrate, wherein at least a portion of a surface of the second substrate in contact with the organic semiconductor single crystal film is hydrophobic, solvent soluble, non-heat resistant, or a combination thereof.

8. The method for manufacturing an organic semiconductor device according to claim 7, wherein the disposing the organic semiconductor single crystal film on the second substrate comprises disposing the second substrate so as to be in contact with the organic semiconductor single crystal film formed on the first substrate while applying water to the interface between the first substrate and the organic semiconductor single crystal film to separate the organic semiconductor single crystal film from the first substrate and dispose the organic semiconductor single crystal film on the second substrate.

9. The method for manufacturing an organic semiconductor device according to claim 7 or 8, wherein the at least a portion of the surface of the second substrate in contact with the organic semiconductor single crystal film has at least one of a concave portion, a convex portion, an uneven portion, and an electrode.
